# EUROPEAN PATENT SPECIFICATION

(11) **EP 2 568 504 B1**
(45) Date of publication and mention of the grant of the patent: **26.07.2017**
(21) Application number: 12165866.0
(22) Date of filing: 27.04.2012
(51) Int. Cl.: H01L 27/32

(54) **ORGANIC LIGHT-EMITTING DISPLAY DEVICE**
ORGANISCHE LICHTEMITTIERENDE ANZEIGEVORRICHTUNG
DISPOSITIF A AFFICHAGE ELECTROLUMINESCENT ORGANIQUE

(30) Priority: 08.09.2011 KR 20110091323
(43) Date of publication of application: 13.03.2013
(73) Proprietor: Samsung Display Co., Ltd., Gyeonggi-do (KR)
(72) Inventor: Eom, Ki-Myeong, 446-711 Yongin-City (KR)
(74) Representative: Gulde & Partner

(56) References cited:
- EP-A2- 1 755 104
- US-A- 5 798 745
- US-A1- 2003 052 618
- US-A1- 2007 075 955
- US-A1- 2007 115 226
- US-A1- 2011 024 756
- US-B1- 7 091 936

## Description

### BACKGROUND OF THE INVENTION

### Field of the Invention

The present invention relates to an organic light-emitting display device, and more particularly, to an organic light-emitting display device including three sub-pixels constituting a unit pixel.

### Description of the Related Art

In general, a unit pixel of an organic light-emitting display device includes a red sub-pixel, a green sub-pixel, and a blue sub-pixel, and a desired color is achieved by combining the colors of the three sub-pixels.

Each of the three sub-pixels includes a thin film transistor, a capacitor, and a light-emitting unit connected to the thin film transistor and the capacitor. The light-emitting unit receives an appropriate driving signal from the thin film transistor and the capacitor to emit light and display a desired image.

US7091936 describes an EL display device wherein the size of a transistor, defined as the ratio W/L, is adapted in each color subpixel such that white balance among the display pixels for different colors can easily be controlled.

US2003/0052618 describes an EL display unit wherein the driving transistors have channel widths and/ or channel lengths to generate the drive currents in a ratio in which each of the N electroluminescence elements is driven to emit light at a desired intensity.

US2007/0075955 describes an OLED display wherein the area occupied by the driving transistor of the color subpixel having the lowest light emission efficiency is larger than the area occupied by the driving transistors of the other color subpixels.

From among the red, green, and blue sub-pixels, the green sub-pixel has the highest light-emitting efficiency. Accordingly, when the three sub-pixels are formed to have the same size as in a conventional method, less current flows through the green sub-pixel. That is, since a sub-pixel having higher efficiency than other sub-pixels has the same brightness with less current than the other sub-pixels, less current flows through the green sub-pixel in order for the three sub-pixels to have the same brightness. In this case, however, since a swing range for displaying gradation is narrowed in the green sub-pixel, more precise control is needed. For example, if gradation having 256 levels is displayed, since the green sub-pixel displays 256 levels with relatively small current, a voltage control range for displaying overall gradation is narrowed in the green sub-pixel compared to that in the other sub-pixels and a voltage difference in one gradation is reduced, thereby making it difficult to control. Accordingly, once the swing range is narrowed, gradation is not accurately displayed even with a slight

### SUMMARY OF THE INVENTION

The present invention provides an organic light-emitting display device which may prevent a swing range of a green sub-pixel from being narrowed due to efficiency difference between sub-pixels having different colors.

According to an aspect of the present invention, there is provided an organic light-emitting display device as recited in claim 1. Preferably, a width to length ratio of the sub-pixel emitting light of the second color ranges from 4:20 to 5:20, and a width to length ratio of the sub-pixel emitting light of the first color ranges from 3:30 to 4:30.

Preferably, in the overlapping area of the thin film transistor of the sub-pixel emitting light of the first color, the gate electrode has a rectangular shape, and the active layer has a T-shape.

Preferably, the capacitor comprises a storage capacitor and a boost capacitor. Preferably, an overlapping area of material layers forming the storage capacitor and the boost capacitor of the sub-pixel emitting light of the first color is greater than an overlapping area of material layers forming the storage capacitor and the boost capacitor of the sub-pixel emitting light of the second color.

Preferably, the material layers forming the storage capacitor comprise first and second storage electrodes and the material layers forming the boost capacitor comprise first and second boost electrodes, wherein the active layer, the first storage electrode and the first boost electrode may be simultaneously formed by a first material layer, and the gate electrode, the second storage electrode and the second boost electrode may be simultaneously formed by a second material layer.

According to another aspect of the present invention, there is provided an organic light-emitting display device including red, green, and blue sub-pixels which emit light having different colors and each of which includes a thin film transistor and a capacitor, wherein a size of the thin film transistor of the green sub-pixel is greater than a size of each of the thin film transistors of the red and blue sub-pixels.

The thin film transistor may include an active layer and a gate electrode, wherein a width of an overlapping region between the active layer and the gate electrode of the green sub-pixel is less than a width of an overlapping region between the active layer and the gate electrode of each of the red and blue sub-pixels.

A length of the overlapping region between the active layer and the gate electrode of the green sub-pixel may be greater than a length of the overlapping region between the active layer and the gate electrode of each of the red and blue sub-pixels.

A width to length ratio of each of the red sub-pixel and the blue sub-pixel may range from 4:20 to 5:20, and a width to length ratio of the green sub-pixel may range from 3:30 to 4:30.

In the overlapping region, the gate electrode may have a rectangular shape, and the active layer may have a T-shape.

The capacitor may include a storage capacitor and a boost capacitor.

Areas of the storage capacitor and the boost capacitor of the green sub-pixel may be greater than areas of the storage capacitor and the boost capacitor of each of the red and blue sub-pixels.

The storage capacitor may include a first storage electrode, which is formed from the same layer as the active layer, and a second storage electrode, which is formed from the same layer as the gate electrode, wherein an overlapping region between the first and second storage electrodes of the green sub-pixel is greater than an overlapping region between the first and second storage electrodes of each of the red and blue sub-pixels.

A plurality of holes may be formed in the first storage electrode.

The boost capacitor may include a first boost electrode, which is formed from the same layer as the active layer, and a second boost electrode, which is formed from the same layer as the gate electrode, wherein an overlapping region between the first and second boost electrodes of the green sub-pixel is greater than an overlapping region between the first and second boost electrodes of each of the red and blue sub-pixels.

The thin film transistor may be a driving transistor.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is a plan view illustrating a unit pixel included in an organic light-emitting display device according to an embodiment of the present invention;
FIGS. 2A and 2B are plan views illustrating different layers on which elements of the unit pixel of FIG. 1 are formed;
FIG. 3A is an enlarged plan view illustrating thin film transistors of the red and green sub-pixels of FIG. 1;
FIG. 3B is an enlarged plan view illustrating boost capacitors of the red and green sub-pixels of FIG. 1;
FIG. 3C is an enlarged plan view illustrating storage capacitors of the red and green sub-pixels of FIG. 1;
FIG. 4 is a cross-sectional view taken along line A-A of FIG. 1;
FIG. 5 is a plan view illustrating a unit pixel included in an organic light-emitting display device according to another embodiment of the present invention; and
FIG. 6 is a plan view illustrating a modifiable example of the thin film transistors of FIG. 3A.

### DETAILED DESCRIPTION OF THE INVENTION

The present invention will now be described more fully with reference to the accompanying drawings, in which exemplary embodiments of the invention are shown.

In the drawings, the same reference numerals denote the same elements. In the description of the present invention, certain detailed explanations of related art are omitted when it is deemed that they may unnecessarily obscure the essence of the invention.

In the drawings, thicknesses of layers or regions may be exaggerated for clarity. Also, it will be understood that when an element, such as a layer, a film, a region, or a plate, is referred to as being "on", "connected to" or "coupled to" another element, it may be directly on, connected or coupled to the other element or intervening elements may be present.

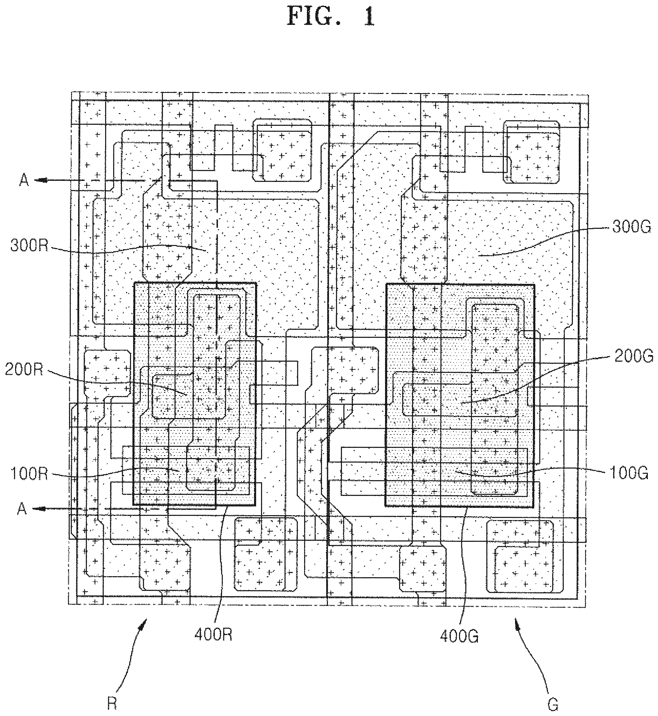

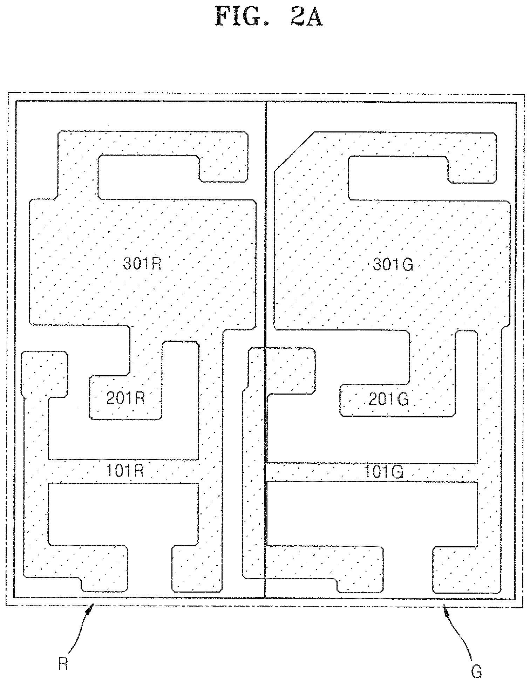

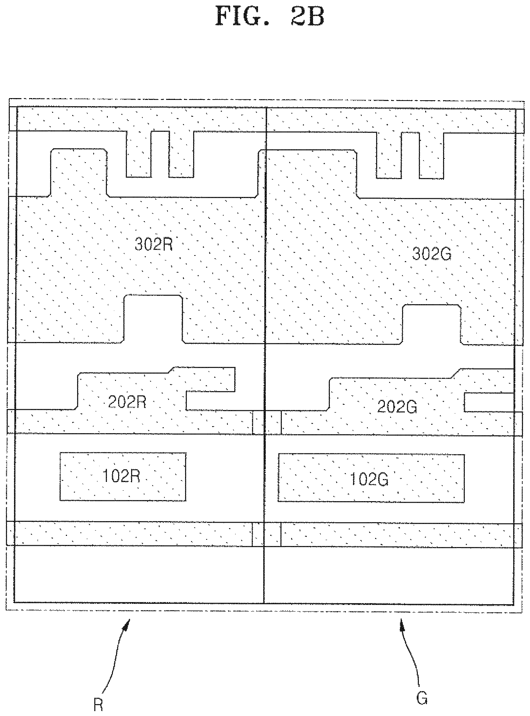

FIG. 1 is a plan view illustrating a unit pixel included in an organic light-emitting display device according to an embodiment of the present invention. FIGS. 2A and 2B are plan views illustrating different layers on which elements of the unit pixel of FIG. 1 are formed. The unit pixel includes three sub-pixels, that is, a red sub-pixel R, a green sub-pixel G, and a blue sub-pixel (not shown). Since the blue sub-pixel and the red sub-pixel R have the same structure in the present embodiment, only the red sub-pixel R is shown in order to be easily compared with the green sub-pixel G. In the organic light-emitting display device, a plurality of the unit pixels each including the three sub-pixels are repeatedly arranged in rows and columns.

Referring to FIG. 1, in the organic light-emitting display device, the three sub-pixels, that is, the red sub-pixel R, the green sub-pixel G, and the blue sub-pixel (not shown), constitute each unit pixel as described above. The blue sub-pixel has the same structure as the red sub-pixel R, and a description of the structure of the red sub-pixel R below also applies for the blue sub-pixel.

First, the red sub-pixel R and the green sub-pixel G respectively include light-emitting units 400R and 400G, thin film transistors 100R and 100G, storage capacitors 300R and 300G, and boost capacitors 200R and 200G. Accordingly, when current flows through the thin film transistors 100R and 100G, the storage capacitors 300R and 300G, and the boost capacitors 200R and 200G, the light-emitting units 400R and 400G connected thereto emit light to thus form an image. The thin film transistors 100R and 100G are driving transistors for driving the light-emitting units 400R and 400G, respectively.

Since the green sub-pixel G has relatively high light-emitting efficiency as described above, if the green sub-pixel G is formed to have the same structure as that of the red sub-pixel R and the blue sub-pixel, current used to emit light is reduced and a swing range is reduced, thereby making it difficult to precisely display gradation.

Accordingly, in order to avoid this problem, in the present embodiment, the thin film transistors 100R and 100G, the storage capacitors 300R and 300G, and the boost capacitors 200R and 200G which are connected to the light-emitting units 400R and 400G are formed to have different sizes.

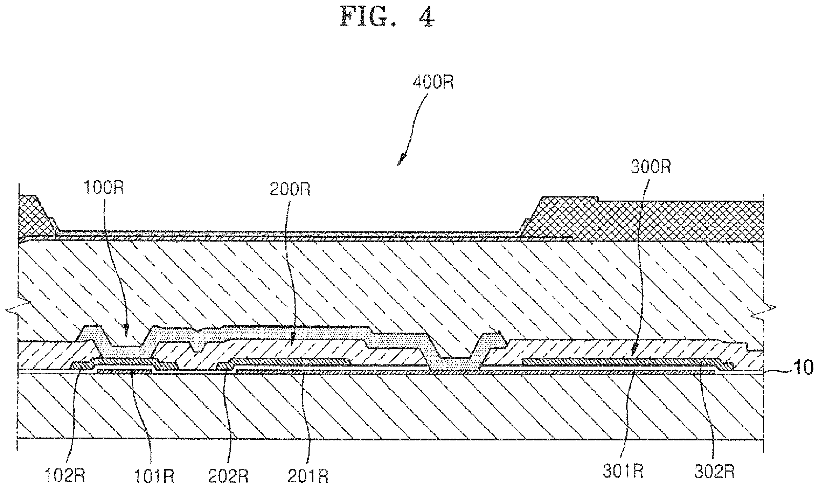

In detail, the structure of the red sub-pixel R will be explained as follows with reference to FIG. 4. FIG. 4 is a cross-sectional view taken along line A-A of FIG. 1. The blue sub-pixel (not shown) has the same structure as that of the red sub-pixel R described above, and the green sub-pixel G has substantially the same structure as that of the red sub-pixel R although there is a difference in size between the green sub-pixel G and the red sub-pixel R. Referring to FIG. 4, the thin film transistor 100R, the storage capacitor 300R, and the boost capacitor 200R which are connected to the light-emitting unit 400R are formed below the light-emitting unit 400R. An active layer 101R and a gate electrode 102R, a first storage electrode 301R and a second storage electrode 302R, and a first boost electrode 201R and a second boost electrode 202R are respectively arranged to face each other with an insulating layer 10 therebetween.

The active layer 101R, the first storage electrode 301R, and the first boost electrode 201R are formed from a same material layer, and the gate electrode 102R, the second storage electrode 302R, and the second boost electrode 202R are formed from a same material layer, as shown in FIGS. 2A and 2B.

That is, the active layers 101R and 101G, the first storage electrodes 301R and 301G, and the first boost electrodes 201R and 201G of the red and green sub-pixels R and G are formed from a same material layer as shown in FIG. 2A, and the gate electrodes 102R and 102G, the second storage electrodes 302R and 302G, and the second boost electrodes 202R and 202G are formed from a same material layer as shown in FIG. 2B.

Structures of FIGS. 2A and 2B are stacked with the insulating layer 10 (FIG. 4) therebetween to form an overlapping region. The thin film transistors 100R and 100G, the storage capacitors 300R and 300G, and the boost capacitors 200R and 200G are formed in the overlapping region.

Elements of the red sub-pixel R and the green sub-pixel G will be compared with each other.

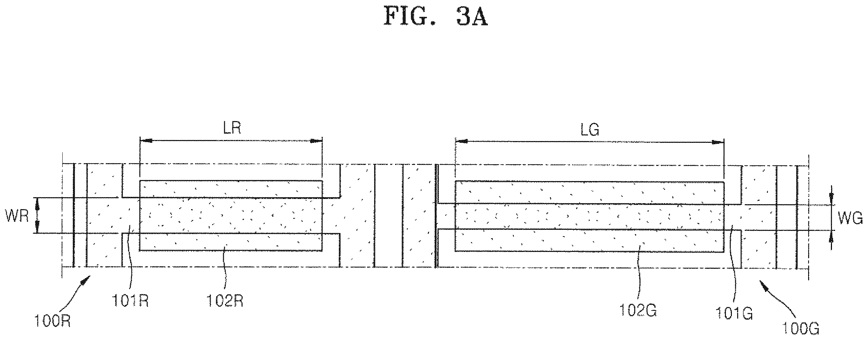

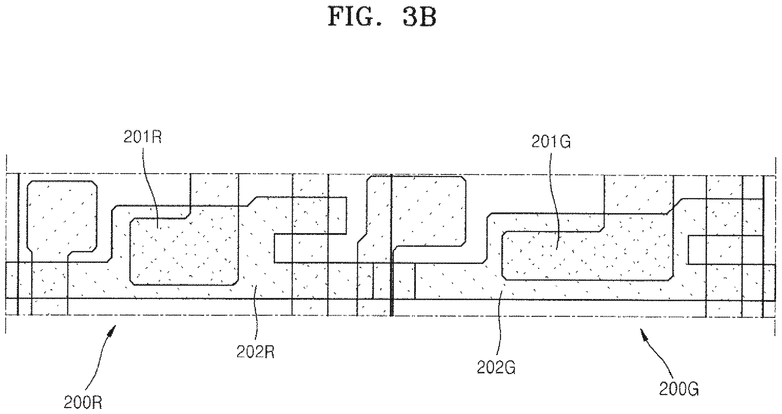

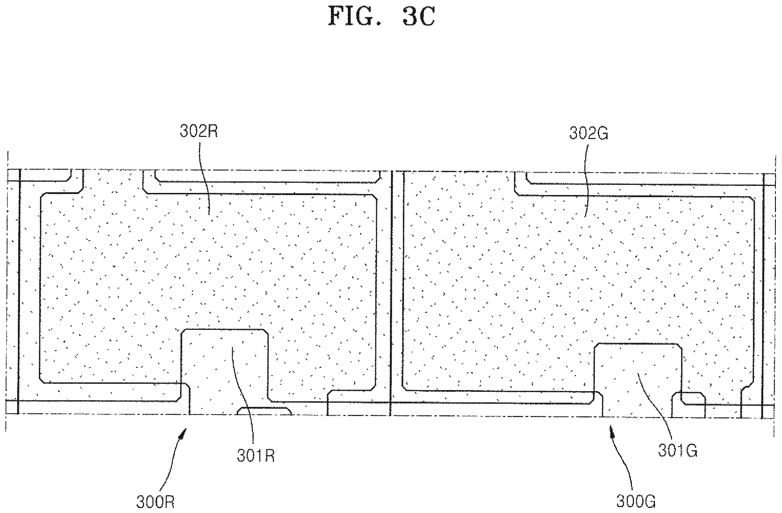

FIG. 3A is an enlarged plan view illustrating the thin film transistors 100R and 100G of the red and green sub-pixels R and G of FIG. 1. FIG. 3B is an enlarged plan view illustrating the boost capacitors 200R and 200G of the red and green sub-pixels R and G of FIG. 1. FIG. 3C is an enlarged plan view illustrating the storage capacitors 300R and 300G of the red and green sub-pixels R and G of FIG. 1.

Referring to FIG. 3A, the thin film transistors 100R and 100G are respectively formed in overlapping regions between the active layers 101R and 101G and the gate electrodes 102R and 102G. When the overlapping regions are compared with each other, a width of the overlapping region of the green sub-pixel G is less than a width of the overlapping region of the red sub-pixel R (WG<WR), and a length of the overlapping region of the green sub-pixel G is greater than a length of the overlapping region of the red sub-pixel R (LG>LR). A total area of the overlapping region of the green sub-pixel G is greater than a total area of the overlapping region of the red sub-pixel R. In detail, if a width (WR) to length (LR) ratio of the overlapping region of the red sub-pixel R ranges from 4:20 to 5:20, a width (WG) to length (LG) ratio of the green sub-pixel G may range from 3:30 to 4:30.

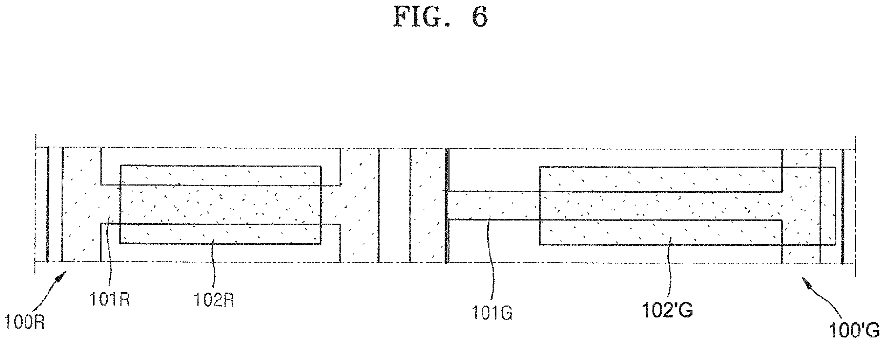

FIG. 6 is a plan view illustrating a modified example of FIG. 3A. The gate electrode 102'G of the green sub-pixel G may be formed to overlap with a T-shaped portion of the active layer 101G. In this case, a length of the thin film transistor 100'G is greater than a length of the thin film transistor 100R of the red sub-pixel R.

If a width of the thin film transistor 100'G is reduced and a length of the thin film transistor 100'G is increased, the amount of current supplied to emit light with a desired brightness is increased. Accordingly, a swing range for displaying overall gradation is increased and a voltage range corresponding to one gradation is widened, thereby making it easy to precisely display gradation. According to experiments, when a width to length ratio is 5:20, a swing range is 1.5 V, and when a width to length ratio is 4:30, a swing range is 1.7 V, which is higher by about 0.2 V than 1.5 V. Accordingly, when gradation having 256 levels is displayed, a voltage difference in one gradation is increased from 5.86 mV to 6.64 mV, thereby making it easy to control.

Also, since the storage capacitors 300R and 300G and the boost capacitors 200R and 200G affect gradation display of the light-emitting units 400R and 400G in the present embodiment, the storage capacitor 300G (FIG. 3C) and the boost capacitor 200G (FIG. 3B) of the green sub-pixel G may be greater in size than the storage capacitor 300R and the boost capacitor 200R of the red sub-pixel R.

That is, referring to FIG. 3B, the boost capacitors 200R and 200G are formed in overlapping regions between the first boost electrodes 201R and 201G and the second boost electrodes 202R and 202G, and an area of the overlapping region of the green sub-pixel G is greater than an area of the overlapping region of the red sub-pixel R. Accordingly, the amount of current supplied in order for the light-emitting unit 400G to emit light with a desired brightness is increased and a swing range for displaying overall gradation is increased, thereby making it easy to precisely display gradation.

Likewise, referring to FIG. 3C, the storage capacitors 300R and 300G are formed in overlapping regions between the first storage electrodes 301R and 301G and the second storage electrodes 302R and 302G. An area of the overlapping region of the green sub-pixel G is greater than an area of the overlapping region of the red sub-pixel R. Accordingly, the amount of current supplied in order for the light-emitting unit 400G to emit light with a desired brightness is increased and a swing range for displaying overall gradation is increased, thereby making it easy to precisely display gradation.

Since the organic light-emitting display device including the unit pixel as described above achieves a wide swing range by allowing the thin film transistor 100G, the storage capacitor 300G, or the boost capacitor 200G of the green sub-pixel G having relatively high light-emitting efficiency to be greater in size than that of the red sub-pixel R or the blue sub-pixel (not shown), precise gradation display may be easily controlled, and thus a highly reliable product having more accurate gradation display may be realized. Also, since a brightness variation of the organic light-emitting display device is reduced, the risk of poor image quality may be reduced.

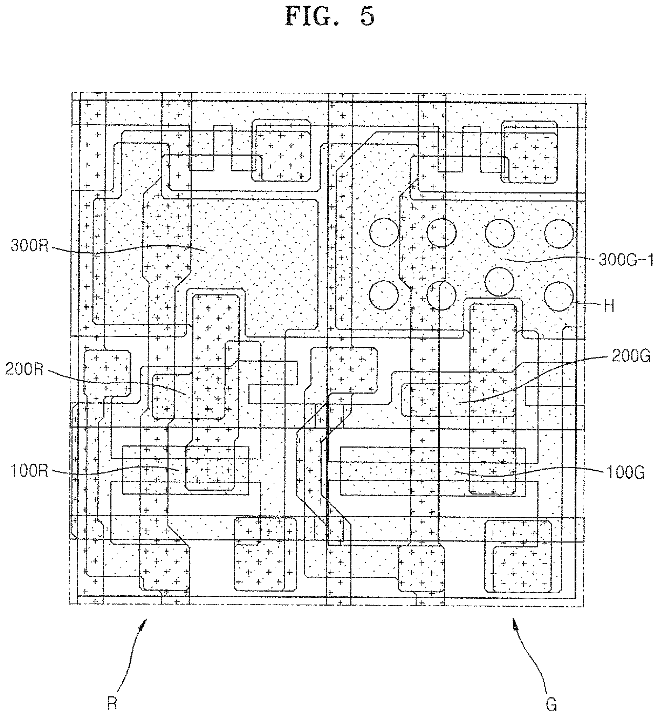

FIG. 5 is a plan view illustrating a unit pixel included in an organic light-emitting display device according to another embodiment of the present invention. Referring to FIG. 5, a plurality of holes H are formed in one of the first or second storage electrodes of a storage capacitor 300G-1 of the green sub-pixel G. That is, when the plurality of holes H are formed in, for example, the second storage electrode, as shown, of the storage capacitor 300G-1 of the green sub-pixel G, an area difference between the storage capacitor 300G-1 and the boost capacitor 200G is reduced. Accordingly, even when a skew, which makes it difficult to precisely pattern the storage capacitor 300G-1 and the boost capacitor 200G, occurs, an extent to which an area difference between the storage capacitor 300G-1 and the boost capacitor 200G is increased may be reduced. As such, additional modifications for achieving various other effects may be made within the scope of the present invention.

As described above, according to an organic light-emitting display device of the present invention, since sizes of a thin film transistor and a capacitor of a sub-pixel having relatively high light-emitting efficiency are greater than sizes of a thin film transistor and a capacitor of each of other sub-pixels to narrow a swing range, gradation display may be easily controlled, a brightness variation of the organic light-emitting display device may be reduced, and the risk of poor image quality may be reduced.

## Claims

1. An organic light-emitting display device comprising sub-pixels (R, G) which emit light of different colors, each sub-pixel (R, G) comprising a thin film transistor (100R, 100G) and a storage capacitor (300R, 300G), an area of the thin film transistor (100G) of the sub-pixel (G) emitting light of a first color being larger than an area of the thin film transistor (100R) of the sub-pixel (R) emitting light of a second color, the first color being green,
wherein each thin film transistor (100R, 100G) comprises an active layer (101R, 101G) and a gate electrode (102R, 102G), the area of the transistor consisting in the overlapping area between the active layer (101R, 101G) and the respective gate electrode (102R, 102G),
wherein a length of the overlapping area of the thin film transistor (100G) of the sub-pixel (G) emitting light of the first color is larger than a length of the overlapping area of the thin film transistor(100R) of the sub-pixel (R) emitting light of the second color, and
**characterized in that**
a width of the overlapping area of the thin film transistor (100G) of the sub-pixel (G) emitting light of the first color is smaller than a width of the overlapping area of the thin film transistor (100R) of the sub-pixel (R) emitting light of the second color.

2. The organic light-emitting display device of claim 1, wherein a width to length ratio of the sub-pixel (R) emitting light of the second color ranges from 4:20 to 5:20, and a width to length ratio of the sub-pixel (G) emitting light of the first color ranges from 3:30 to 4:30.

3. The organic light-emitting display device of claim 1, wherein in the overlapping area of the thin film transistor (100'G) of the sub-pixel emitting light of the first color, the gate electrode (102'G) has a rectangular shape, and the active layer (101G) has a T-shape.

4. The organic light-emitting display device of one of the preceding claims, each sub-pixel further comprising a boost capacitor (200R, 200G).

5. The organic light-emitting display device of claim 4, wherein each storage capacitor (300R, 300G) comprises first and second storage electrodes (301G, 302G, 301R, 302R) and an overlapping area of first and second storage electrodes (301G, 302G) forming the storage capacitor (300G) of the sub-pixel (G) emitting light of the first color is larger than an overlapping area of first and second storage electrodes (301R, 302R) forming the storage capacitor (300R) of the sub-pixel (R) emitting light of the second color, and
wherein each boost capacitor (200R, 200G) comprises first and second boost electrodes (201G, 202G, 201R, 202R) and an overlapping area of the first and second boost electrodes (201G, 202G) forming the boost capacitor (200G) of the sub-pixel (G) emitting light of the first color is larger than an overlapping area of the first and second boost electrodes (201R, 202R) forming the boost capacitor of the sub-pixel (R) emitting light of the second color.

6. The organic light-emitting display device of claim 5, wherein the active layer(101R, 101G), the first storage electrode (301G, 301R) and the first boost electrode (201G, 201R) are simultaneously formed by a first material layer, and the gate electrode (102G, 102R), the second storage electrode (302G, 302R) and the second boost electrode (202G, 202R) are simultaneously formed by a second material layer.

7. The organic light-emitting display device of claim 6, further comprising a plurality of holes (H) formed in one of the first or second storage electrodes (301G, 302G) of the storage capacitor (300G-1) of the sub-pixel (G) emitting light of the first color.

8. The organic light-emitting display device of claim 6, further comprising an insulating layer (10) formed between the first material layer and the second material layer.

9. The organic light-emitting display device of one of the preceding claims, wherein the thin film transistor (100R, 100G) is a driving transistor.

10. The organic light-emitting display device of one of the preceding claims, wherein the second color is red or blue.

11. The organic light-emitting display device of one of the preceding claims, comprising green, red and blue sub-pixels, wherein an area of the thin film transistor (100G) of the green sub-pixel is larger than an area of each of the thin film transistors (100R) of the red and blue sub-pixels.

## Patentansprüche

1. Organische lichtemittierende Anzeigevorrichtung, aufweisend Subpixel (R, G), die Licht verschiedener Farben emittieren, wobei jeder Subpixel (R, G) einen Dünnfilmtransistor (100R, 100G) und einen Speicherkondensator (300R, 300G) aufweist, wobei ein Bereich des Dünnfilmtransistors (100G) des Subpixels (G), der Licht einer ersten Farbe emittiert, größer ist als ein Bereich des Dünnfilmtransistors (100R) des Subpixels (R), der Licht einer zweiten Farbe emittiert, wobei die erste Farbe Grün ist,
wobei jeder Dünnfilmtransistor (100R, 100G) eine aktive Schicht (101R, 101G) und eine Gate-Elektrode (102R, 102G) aufweist, wobei der Bereich des Transistors im überlappenden Bereich zwischen der aktiven Schicht (101R, 101G) und der jeweiligen Gate-Elektrode (102R, 102G) besteht,
wobei eine Länge des überlappenden Bereichs des Dünnfilmtransistors (100G) des Subpixels (G), der Licht der ersten Farbe emittiert, größer ist als eine Länge des überlappenden Bereichs des Dünnfilmtransistors (100R) des Subpixels (R), der Licht der zweiten Farbe emittiert, und
**dadurch gekennzeichnet, dass**
eine Breite des überlappenden Bereichs des Dünnfilmtransistors (100G) des Subpixels (G), der Licht der ersten Farbe emittiert, kleiner ist als eine Breite des überlappenden Bereichs des Dünnfilmtransistors (100R) des Subpixels (R), der Licht der zweiten Farbe emittiert.

2. Organische lichtemittierende Anzeigevorrichtung nach Anspruch 1, wobei ein Verhältnis von Breite zu Länge des Subpixels (R), der Licht der zweiten Farbe emittiert, in einem Bereich von 4:20 bis 5:20 liegt, und ein Verhältnis von Breite zu Länge des Subpixels (G), der Licht der ersten Farbe emittiert, in einem Bereich von 3:30 bis 4:30 liegt.

3. Organische lichtemittierende Anzeigevorrichtung nach Anspruch 1, wobei im überlappenden Bereich des Dünnfilmtransistors (100'G) des Subpixels, der Licht der ersten Farbe emittiert, die Gate-Elektrode (102'G) eine Rechteckform aufweist und die aktive Schicht (101G) eine T-Form aufweist.

4. Organische lichtemittierende Anzeigevorrichtung nach einem der vorhergehenden Ansprüche, wobei jeder Subpixel ferner einen Verstärkungskondensator (200R, 200G) aufweist.

5. Organische lichtemittierende Anzeigevorrichtung nach Anspruch 4, wobei jeder Speicherkondensator (300R, 300G) eine erste und zweite Speicherelektrode (301G, 302G 301R, 302R) aufweist und ein überlappender Bereich der ersten und zweiten Speicherelektrode (301G, 302G), der den Speicherkondensator (300G) des Subpixels (G), der Licht der ersten Farbe emittiert, ausbildet, größer ist als ein überlappender Bereich der ersten und zweiten Speicherelektrode (301R, 302R), der den Speicherkondensator (300R) des Subpixels (R), der Licht der zweiten Farbe emittiert, ausbildet, und
wobei jeder Verstärkungskondensator (200R, 200G) eine erste und zweite Verstärkungselektrode (201G, 202G, 201R, 202R) aufweist und ein überlappender Bereich der ersten und zweiten Verstärkungselektrode (201G, 202G), der den Verstärkungskondensator (200G) des Subpixels (G), der Licht der ersten Farbe emittiert, ausbildet, größer ist als ein überlappender Bereich der ersten und zweiten Verstärkungselektrode (201R, 202R), der den Verstärkungskondensator des Subpixels (R), der Licht der zweiten Farbe emittiert, ausbildet.

6. Organische lichtemittierende Anzeigevorrichtung nach Anspruch 5, wobei die aktive Schicht (101R, 101G), die erste Speicherelektrode (301G, 301R) und die erste Verstärkungselektrode (201G, 201R) gleichzeitig von einer ersten Materialschicht ausgebildet werden und die Gate-Elektrode (102G, 102R), die zweite Speicherelektrode (302G, 302R) und die zweite Verstärkungselektrode (202G, 202R) gleichzeitig von einer zweiten Materialschicht ausgebildet werden.

7. Organische lichtemittierende Anzeigevorrichtung nach Anspruch 6, ferner aufweisend eine Vielzahl von Löchern (H), die in einer der ersten oder zweiten Speicherelektrode (301G, 302G) des Speicherkondensators (300G-1) des Subpixels (G), der Licht der ersten Farbe emittiert, ausgebildet sind.

8. Organische lichtemittierende Anzeigevorrichtung nach Anspruch 6, ferner aufweisend eine Isolierschicht (10), die zwischen der ersten Materialschicht und der zweiten Materialschicht ausgebildet ist.

9. Organische lichtemittierende Anzeigevorrichtung nach einem der vorhergehenden Ansprüche, wobei der Dünnfilmtransistor (100R, 100G) ein Ansteuertransistor ist.

10. Organische lichtemittierende Anzeigevorrichtung nach einem der vorhergehenden Ansprüche, wobei die zweite Farbe Rot oder Blau ist.

11. Organische lichtemittierende Anzeigevorrichtung nach einem der vorhergehenden Ansprüche, aufweisend grüne, rote und blaue Subpixel, wobei ein Bereich des Dünnfilmtransistors (100G) des grünen Subpixels größer ist als ein Bereich jedes des Dünnfilmtransistors (100R) des roten und blauen Subpixels.

## Revendications

1. Dispositif d'affichage électroluminescent organique comprenant des sous-pixels (R, G) qui émettent de la lumière de différentes couleurs, chaque sous-pixel (R, G) comprenant un transistor à couches minces (100R, 100G) et un condensateur de stockage (300R, 300G), une surface du transistor à couches minces (100G) du sous-pixel (G) émettant de la lumière d'une première couleur étant supérieure à une surface du transistor à couches minces (100R) du sous-pixel (R) émettant de la lumière d'une deuxième couleur, la première couleur étant verte,
dans lequel chaque transistor à couches minces (100R, 100G) comprend une couche active (101R, 101G) et une électrode de grille (102R, 102G), la surface du transistor consistant en la zone de chevauchement entre la couche active (101R, 101G) et l'électrode de grille respective (102R, 102G),
dans lequel une longueur de la zone de chevauchement du transistor à couches minces (100G) du sous-pixel (G) émettant de la lumière de la première couleur est supérieure à une longueur de la zone de chevauchement du transistor à couches minces (100R) du sous-pixel (R) émettant de la lumière de la deuxième couleur, et
**caractérisé en ce que** :
une largeur de la zone de chevauchement du transistor à couches minces (100G) du sous-pixel (G) émettant de la lumière de la première couleur est inférieure à une largeur de la zone de chevauchement du transistor à couches minces (100R) du sous-pixel (R) émettant de la lumière de la deuxième couleur.

2. Dispositif d'affichage électroluminescent organique de la revendication 1, dans lequel un rapport de la largeur sur la longueur du sous-pixel (R) émettant de la lumière de la deuxième couleur se trouve dans une plage allant de 4:20 à 5:20, et un rapport de la largeur sur la longueur du sous-pixel (G) émettant de la lumière de la première couleur se trouve dans une plage allant de 3:30 à 4:30.

3. Dispositif d'affichage électroluminescent organique de la revendication 1, dans lequel, dans la zone de chevauchement du transistor à couches minces (100'G) du sous-pixel émettant de la lumière de la première couleur, l'électrode de grille (102'G) présente une forme rectangulaire, et la couche active (101G) présente une forme en T.

4. Dispositif d'affichage électroluminescent organique de l'une des revendications précédentes, chaque sous-pixel comprenant en outre un condensateur de suralimentation (200R, 200G).

5. Dispositif d'affichage électroluminescent organique de la revendication 4, dans lequel chaque condensateur de stockage (300R, 300G) comprend des première et deuxième électrodes de stockage (301G, 302G, 301R, 302R) et une zone de chevauchement de première et deuxième électrodes de stockage (301G, 302G) formant le condensateur de stockage (300G) du sous-pixel (G) émettant de la lumière de la première couleur est plus grande qu'une zone de chevauchement des première et deuxième électrodes de stockage (301R, 302R) formant le condensateur de stockage (300R) du sous-pixel (R) émettant de la lumière de la deuxième couleur, et
dans lequel chaque condensateur de suralimentation (200R, 200G) comprend des première et deuxième électrodes de suralimentation (201G, 202G, 201R, 202R) et une zone de chevauchement des première et deuxième électrodes de suralimentation (201G, 202G) formant le condensateur de suralimentation (200G) du sous-pixel (G) émettant de la lumière de la première couleur est plus grande qu'une zone de chevauchement des première et deuxième électrodes de suralimentation (201R, 202R) formant le condensateur de suralimentation du sous-pixel (R) émettant de la lumière de la deuxième couleur.

6. Dispositif d'affichage électroluminescent organique de la revendication 5, dans lequel la couche active (101R, 101G), la première électrode de stockage (301G, 301R) et la première électrode de suralimentation (201G, 201R) sont formées simultanément par une première couche de matériau, et l'électrode de grille (102G, 102R), la deuxième électrode de stockage (302G, 302R) et la deuxième électrode de suralimentation (202G, 202R) sont formées simultanément par une deuxième couche de matériau.

7. Dispositif d'affichage électroluminescent organique de la revendication 6, comprenant en outre une pluralité de trous (H) formés dans l'une des première et deuxième électrodes de stockage (301G, 302G) du condensateur de stockage (300G-1) du sous-pixel (G) émettant de la lumière de la première couleur.

8. Dispositif d'affichage électroluminescent organique de la revendication 6, comprenant en outre une couche d'isolation (10) formée entre la première couche de matériau et la deuxième couche de matériau.

9. Dispositif d'affichage électroluminescent organique de l'une des revendications précédentes, dans lequel le transistor à couches minces (100R, 100G) est un transistor d'attaque.

10. Dispositif d'affichage électroluminescent organique de l'une des revendications précédentes, dans lequel la deuxième couleur est le rouge ou le bleu.

11. Dispositif d'affichage électroluminescent organique de l'une des revendications précédentes, comprenant des sous-pixels verts, rouges et bleus, dans lequel une surface du transistor à couches minces (100G) du sous-pixel vert est supérieure à une surface de chacun des transistors à couches minces (100R) des sous-pixels rouges et bleus.
